# EUROPÄISCHE PATENTSCHRIFT

(11) **EP 1 114 467 B1**
(45) Veröffentlichungstag und Bekanntmachung des Hinweises auf die Patenterteilung: **24.05.2006**
(21) Anmeldenummer: 99945921.7
(22) Anmeldetag: 05.07.1999
(51) Int. Cl.: H01L 29/786, H01L 29/49

(54) **FERROELEKTRISCHER TRANSISTOR, DESSEN VERWENDUNG IN EINER SPEICHERZELLENANORDNUNG UND VERFAHREN ZU DESSEN HERSTELLUNG**
FERROELECTRIC TRANSISTOR, ITS USE IN A STORAGE CELL SYSTEM AND ITS METHOD OF PRODUCTION
TRANSISTOR FERROELECTRIQUE, SON UTILISATION DANS UN SYSTEME CELLULE DE MEMOIRE ET SON PROCEDE DE PRODUCTION

(30) Priorität: 07.09.1998 DE 19840824
(43) Veröffentlichungstag der Anmeldung: 11.07.2001
(73) Patentinhaber: Infineon Technologies AG, 81669 München (DE)
(72) Erfinder: HANEDER, Thomas, Peter, D-81549 München (DE); REISINGER, Hans, D-82031 Grünwald (DE); STENGL, Reinhard, D-86391 Stadtbergen (DE); BACHHOFER, Harald, D-81677 München (DE); WENDT, Hermann, D-85630 Grasbrunn (DE); HÖNLEIN, Wolfgang, D-82008 Unterhaching (DE)
(74) Vertreter: Ginzel, Christian
(86) Internationale Anmeldenummer: PCT/DE1999/002083
(87) Internationale Veröffentlichungsnummer: WO 2000/014808

(56) Entgegenhaltungen:
- EP-A- 0 459 773
- EP-A- 0 716 455
- TAKASHI NAKAMURA ET AL: "WP 4.3: A SINGLE-TRANSISTOR FERROELECTRIC MEMORY CELL" IEEE INTERNATIONAL SOLID STATE CIRCUITS CONFERENCE,US,IEEE INC. NEW YORK, Bd. 38, Seite 68-69,340 XP000557557 ISSN: 0193-6530 in der Anmeldung erwähnt

## Beschreibung

Die Erfindung betrifft einen ferroelektrischen Transistor, der zwei Source-/Drain-Gebiete, einen Kanalbereich und eine Gateelektrode aufweist, wobei zwischen der Gateelektrode und dem Kanalbereich eine Schicht aus ferroelektrischem Material vorgesehen ist. Die Leitfähigkeit dieses Transistors ist von dem Polarisationszustand der Schicht aus ferroelektrischem Material abhängig. Derartige ferroelektrische Transistoren werden im Hinblick auf nichtflüchtige Speicher untersucht. Dabei werden zwei verschiedenen logischen Werten einer digitalen Information zwei verschiedene Polarisationszustände der Schicht aus ferroelektrischem Material zugeordnet. Weitere Einsatzmöglichkeiten für derartige ferroelektrische Transistoren sind zum Beispiel neuronale Netze.

Es ist bekannt (siehe zum Beispiel T. Nakamura, Y. Nakao, A. Kamisawa, H. Takasu: A Single Transistor Ferroelectric Memory Cell, IEEE, ISSCC, 1995, Seiten 68 bis 69), ferroelektrische Transistoren als Speicherzellen einer Speicherzellenanordnung zu verwenden. Dabei wird jeder der ferroelektrischen Transistoren zwischen eine Versorgungsspannungsleitung und eine Bitleitung geschaltet. Die Auswahl erfolgt über ein back gate. Die verwendeten ferroelektrischen Transistoren weisen dabei zwischen der ferroelektrischen Schicht und dem Gateoxid eine Floating Gate Elektrode auf, deren Ladung über den Polarisationszustand der ferroelektrischen Schicht gesteuert wird.

Es hat sich gezeigt, daß beim Lesen der Information auch an nicht ausgewählten Speicherzellen Spannung abfällt, die zu einer Verfälschung der in den einzelnen Speicherzellen gespeicherten Information führen kann. Diese Verfälschung wird darauf zurückgeführt, daß Umklapp-Prozesse der Domänen in ferroelektrischen Materialien von statistischer Natur sind und bereits bei niedrigen Spannungen hervorgerufen werden können.

Der Erfindung liegt daher das Problem zugrunde, einen ferroelektrischen Transistor anzugeben, der als Speicherzelle einer Speicherzellenanordnung geeignet ist und in dem eine Veränderung der eingeschriebenen Information beim Lesevorgang vermieden wird. Ferner soll ein Verfahren zu dessen Herstellung angegeben werden.

Dieses Problem wird gelöst durch einen ferroelektrischen Transistor gemäß Anspruch 1 sowie ein Verfahren zu dessen Herstellung gemäß Anspruch 11. Weitere Ausgestaltungen der Erfindung gehen aus den übrigen Ansprüchen hervor.

Der ferroelektrische Transistor weist zwei Source-/Drain-Gebiete auf, die in einem Halbleitersubstrat angeordnet sind. Als Halbleitersubstrat sind alle Halbleitermaterialien geeignet, insbesondere monokristallines Silizium. Das Halbleitersubstrat kann dabei sowohl eine monokristalline Siliziumscheibe als auch ein SOI-Substrat sein.

Zwischen den beiden Source-/Drain-Gebieten sind an der Oberfläche des Halbleitersubstrats eine erste Gatezwischenschicht und eine erste Gateelektrode angeordnet, wobei die erste Gatezwischenschicht mindestens eine ferroelektrische Schicht enthält. Zwischen den Source-/Drain-Gebieten ist in Richtung einer Verbindungslinie zwischen den Source-/Drain-Gebieten neben der ersten Gatezwischenschicht eine zweite Gatezwischenschicht und eine zweite Gateelektrode angeordnet, wobei die zweite Gatezwischenschicht eine dielektrische Schicht enthält. Die erste Gateelektrode und die zweite Gateelektrode sind über eine Diodenstruktur miteinander verbunden.

In diesem ferroelektrischen Transistor sind nebeneinander entlang der Verbindungslinie zwischen den Source-/Drain-Gebieten die erste Gateelektrode und die zweite Gateelektrode angeordnet. Der Kanalbereich des ferroelektroschen Transistors ist somit unterteilt, wobei ein Teil des Kanalbereichs, der unter der ersten Gateelektrode angeordnet ist, durch die an der ersten Gateelektrode wirksamen Ladung ansteuerbar ist und ein Teil des Kanalbereichs, der unter der zweiten Gateelektrode angeordnet ist, durch die an der zweiten Gateelektrode wirksamen Ladung ansteuerbar ist. Zwischen den Source-/Draingebieten kann nur dann ein Strom fließen, wenn sowohl der Teil des Kanalbereichs unterhalb der ersten Gateelektrode als der Teil des Kanalbereichs unterhalb der zweiten Gateelektrode leitend ist.

Die Diodenstruktur ist so gepolt, daß bei Anliegen einer Spannung an der zweiten Gateelektrode, die die Leitfähigkeit des Kanalbereiches unter der zweiten Gateelektrode steuert, die Diodenstruktur sperrt und dadurch die erste Gateelektrode von dieser Spannung getrennt ist.

Bei Verwendung des ferroelektrischen Transistors als Speicher für digitale Information werden in der ferroelektrischen Schicht zwei Polarisationszustände den logischen Werten zugeordnet. Bei dem einen Polarisationszustand ist der Kanalbereich unterhalb der ersten Gateelektrode und der ferroelektrischen Schicht leitend, bei dem anderen nicht.

Da die erste Gateelektrode und die zweite Gateelektrode in Richtung der Verbindungslinie zwischen den Source-/Drain-Gebieten nebeneinander angeordnet sind, ist für den Lesevorgang die Ansteuerung über die zweite Gateelektrode ausreichend. Abhängig vom Polarisationszustand der ferroelektrischen Schicht ist der Kanalbereich unterhalb der ersten Gateelektrode leitend oder nicht. Durch Ansteuerung der zweiten Gateelektrode so, daß der Transistor im Bereich der zweiten Gateelektrode eingeschaltet wird, wird die Information ausgelesen, wobei bewertet wird, ob ein Strom über den Transistor fließt oder nicht.

Die Diodenstruktur, die zwischen die erste Gateelektrode und die zweite Gateelektrode geschaltet ist, stellt sicher, daß die Spannung zur Ansteuerung der zweiten Gateelektrode nur über die zweite Gateelektrode abfällt. Die erste Gateelektrode ist über die Diodenstruktur von dieser Spannung getrennt, so daß über die ferroelektrische Schicht keine Spannung abfällt. Dadurch wird eine Veränderung der Polarisation der ferroelektrischen Schicht und damit der gespeicherten Information vermieden.

Alternativ kann an die zweite Gateelektrode eine Spannung angelegt werden, um die ferroelektrische Schicht zu polarisieren. Dieses wird zum Einschreiben und Löschen von Information verwendet.

Das Einschreiben der Information erfolgt dabei durch eine Spannung die größer als die Sperrspannung der Diodenstruktur ist und die die ferroelektrische Schicht in die eine Richtung polarisiert.

Das Löschen der Information erfolgt durch eine Spannung mit anderem Vorzeichen, so daß die Diodenstruktur in Durchlaßrichtung gepolt ist und die an der ferroelektrischen Schicht abfallende Spannung diese in die andere Richtung polarisiert.

Die Begriffe Schreiben und Löschen von Information können in diesem Zusammenhang auch vice versa verwendet werden.

Vorzugsweise sind die zweite Gatezwischenschicht und die zweite Gateelektrode jeweils aus zwei Teilstrukturen zusammengesetzt, die spiegelsymmetrisch zu der ersten Gatezwischenschicht angeordnet sind. Die beiden Teilstrukturen der zweiten Gateelektrode sind elektrisch miteinander verbunden. Diese Ausgestaltung hat den Vorteil, daß die an der zweiten Gateelektrode anliegende Spannung beim Lesebetrieb ein derartiges elektrisches Feld hervorruft, daß die ferroelektrische Schicht auf einer Äquipotentiallinie liegt und somit keinerlei Veränderung der Polarisation der ferroelektrischen Schicht auftritt. Diese Ausgestaltung der Erfindung ist besonders unempfindlich gegenüber Störungen.

Es ist vorteilhaft, zwischen der Oberfläche des Halbleitersubstrats und der ferroelektrischen Schicht eine dielektrische Schicht vorzusehen, die das Aufbringen der ferroelektrischen Schicht erleichtert.

Im Hinblick auf die Herstellung des ferroelektrischen Transistors ist es vorteilhaft, die dielektrische Schicht, die in der ersten Gatezwischenschicht zwischen der Halbleiteroberfläche und der ferroelektrischen Schicht angeordnet und die dielektrische Schicht, die Bestandteil der zweiten Gatezwischenschicht ist, als durchgehende elektrische Schicht zu bilden, an deren Oberfläche der Stapel aus ferroelektrischer Schicht und erster Gateelektrode erzeugt wird.

Vorzugsweise sind die erste Gateelektrode und/oder die zweite Gateelektrode Teil der Diodenstruktur. Auf diese Weise sinkt der Platzbedarf der Diodenstruktur.

Vorzugsweise weist die erste Gateelektrode polykristallines Silizium auf, das von einem ersten Leitfähigkeitstyp dotiert ist. Die zweite Gateelektrode weist ebenfalls polykristallines Silizium auf, das von einem zweiten, dem ersten entgegengesetzten Leitfähigkeitstyp dotiert ist. Die erste Gatelektrode grenzt dabei an die zweite Gateelektrode an, so daß die Diodenstruktur durch die erste Gateelektrode und die zweite Gateelektrode gebildet wird. In dieser Ausgestaltung sind zum Betrieb des ferroelektrischen Transistors nur drei Anschlüsse erforderlich, zwei an den Source-/Drain-Gebieten und einer an der zweite Gateelektrode. Alternativ können in dieser Ausgestaltung die erste Gateelektrode und die zweite Gateelektrode jeweils aus entsprechend dotiertem epitaktisch aufgewachsenem Silizium gebildet werden.

Aus technologischen Gründen kann es vorteilhaft sein, zwischen der ferroelektrischen Schicht und der ersten Gatelektrode eine Hilfsschicht zum Beispiel aus Platin vorzusehen, die unerwünschte Eigenschaften der ferroelektrischen Sschicht wie zum Beispiel Fatigue oder Imprint Reistance vermeidet.

Es liegt im Rahmen der Erfindung, daß die erste Gatezwischenschicht eine dielektrische Schicht aus CeO₂, ZrO₂, Y₂O₃ oder einem anderen Oxid mit möglichst großer dielektrischer Suzeptibilität zum Beispiel SrTiO₃ enthält. Für die dielektrische Schicht in der zweiten Gatezwischenschicht ist insbesondere SiO₂, CeO₂, ZrO₂, Y₂O₃ oder ein andere Oxid mit möglichst großer dielektrischer Suzeptibilität zum Beispiel SrTiO₃ geeignet. Die ferroelektrische Schicht kann unter anderem aus Strontium-Wismuth-Tantalat (SBT), Blei-Zirkonium-Titanat (PZT), Lithium-Niobat (LiNbO₃) oder Barium-Strontium-Titanat (BST) sein.

Der ferroelektrische Transistor ist vorteilhaft einsetzbar als Speicherzelle in einer Speicherzellenanordnung. Im Hinblick auf die Störsicherheit der Speicherzellenanordnung beim Lesen, Schreiben und Löschen der Information ist es dabei vorteilhaft, in jeder Speicherzelle zusätzlich zu dem ferroelektrischen Transistor einen Auswahltransistor mit einer Steuerelektrode vorzusehen. Darüber hinaus weist die Speicherzellenanordnung Wortleitungen, Bitleitungen und Versorgungsleitungen auf, wobei die Wortleitungen die Versorgungsleitungen und die Bitleitungen kreuzen. Der ferroelektrische Transistor einer der Speicherzellen ist jeweils zwischen zwei benachbarte Bitleitungen geschaltet. Der Auswahltransistor ist zwischen die zweite Gateelektrode und eine der Versorgungsspannungsleitungen geschaltet. Die Steuerelektrode des Auswahltransistors ist jeweils mit einer der Wortleitungen verbunden.

Im folgenden wird die Erfindung anhand von Ausführungsbeispielen und den Figuren näher erläutert.
- Figur 1: zeigt einen Schnitt durch einen ferroelektrischen Transistor.
- Figur 2: zeigt einen Schnitt durch einen ferroelektrischen Transistor, bei dem die erste Gatezwischenschicht und die zweite Gatezwischenschicht eine durchgehende dielektrische Schicht aufweist.
- Figur 3 bis 5: zeigt Schritte bei der Herstellung des ferroelektrischen Transistors, der in Figur 2 dargestellt ist.
- Figur 6: zeigt eine Schaltskizze für eine Speicherzellenanordnung.

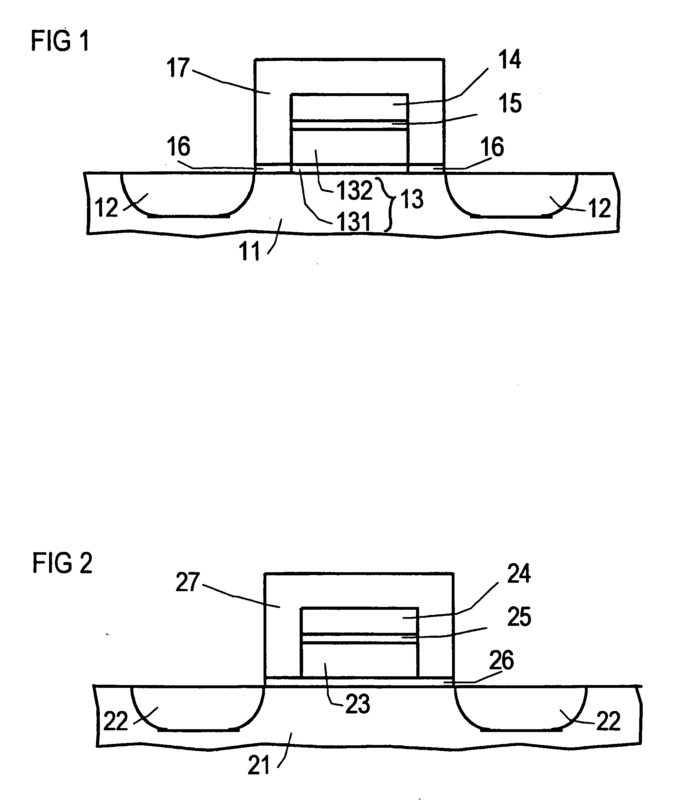

In einem p-dotierten Halbleitersubstrat 11 aus monokristallinem Silizium sind zwei Source-/Drain-Gebiete 12 angeordnet. Zwischen den Source-/Drain-Gebieten 12 ist an der Oberfläche des Halbleitersubstrats 11 eine erste Gatezwischenschicht 13 und eine erste Gateelektrode 14 angeordnet (siehe Figur 1). Die erste Gatezwischenschicht 13 weist in Richtung der Verbindungslinie zwischen den Source-/Drain-Gebieten 12 eine geringere Abmessung auf, als es dem Abstand zwischen den Source-/Drain-Gebieten 12 entspricht. Die erste Gatezwischenschicht 13 weist eine erste dielektrische Schicht 131 und eine ferroelektrische Schicht 132 auf. Die erste dielektrische Schicht 131 enthält CeO₂ und weist eine Dicke von 5 bis 10 nm auf. Die ferroelektrische Schicht 132 weist eine Dicke von 50 bis 100 nm auf und enthält Strontium-Wismuth-Tantalat (SBT) oder Blei-Zirkonium-Titanat (PZT). Die erste Gateelektrode 14 weist eine Dicke von 30 bis 50 nm auf und ist aus p⁺-dotiertem Polysilizium mit einer Dotierstoffkonzentration von einigen 10¹⁹ cm⁻³ gebildet. Zwischen der ersten Gateelektrode 14 und der ferroelektrischen Schicht 132 ist eine Hilfsschicht 15 angeordnet, die zum Schutz der ferroelektrischen Schicht 132 dient und die in einer Dicke von 30 nm aus Platin gebildet ist.

Seitlich der ersten dielektrischen Schicht 131 ist eine zweite dielektrische Schicht 16 aus SiO₂ in einer Schichtdicke von 5 bis 10 nm angeordnet. Die zweite dielektrische Schicht 16 besteht aus zwei Teilen, wobei ein Teil zwischen einem der Source-/Drain-Gebiete 12 und der ersten dielektrischen Schicht 131 und das andere Teil zwischen dem anderen Source/Drain-Gebiet 12 und der ersten dielektrischen Schicht 131 angeordnet ist. Die beiden Teile der zweiten dielektrischen Schicht 16 sind spiegelsymmetrisch zur ersten dielektrischen Schicht 131 angeordnet. Die beiden Teile der zweiten dielektrischen Schicht 16 wirken als zweite Gatezwischenschicht. Oberhalb der zweiten dielektrischen Schicht 16 ist eine zweite Gateelektrode 17 aus n⁺-dotiertem Polysilizium angeordnet. Die zweite Gateelektrode 17 überdeckt die erste Gateelektrode 14, so daß sie in dem in Figur 1 dargestellten Schnitt einen U-förmigen Querschnitt aufweist. Dadurch sind die beiden Teile der zweiten Gateelektrode 17, die an der Oberfläche der beiden Teile der zweiten dielektrischen Schicht 16 angeordnet sind, miteinander elektrisch verbunden. Ferner grenzt die zweite Gateelektrode 17 an die Oberfläche der ersten Gateelektrode 14 an. Die erste Gateelektrode 14 und die zweite Gateelektrode 17 bilden gemeinsam eine Diodenstruktur.

Zum Einschreiben von Information in den ferroelektrischen Transistor wird der pn-Übergang, der aus der ersten Gateelektrode 14 und der zweiten Gateelektrode 17 gebildet wird, in Durchlaßrichtung betrieben, das heißt, es wird ein negativer Spannungspuls an die n⁺-dotierte zweite Gateelektrode 17 angelegt. Dadurch wird die ferroelektrische Schicht 132 so polarisiert, daß sich der unter der ersten Gatezwischenschicht 13 angeordnete Teil des Kanalbereichs in Akkumulation befindet und daher sperrt.

Zum Lesen des Speichertransistors wird dagegen der pn-Übergang, der aus erster Gateelektrode 14 und zweiter Gateelektrode 17 gebildet wird, in Sperrichtung unterhalb der Durchbruchsspannung betrieben. Dadurch wird über die zweite Gateelektrode 17 beiderseits der ferroelektrischen Schicht 132 der Kanalbereich in Inversion gebracht, ohne daß sich dabei der Polarisationszustand der ferroelektrischen Schicht 132 ändert. Ein Strom über den Transistor fließt nur dann, wenn die ferroelektrische Schicht 132 so polarisiert ist, daß sich auch in den Teil des Kanalbereichs, der unterhalb der ersten Gatezwischenschicht 13, das heißt, unterhalb der ferroelektrischen Schicht 132, befindet, in Inversion befindet. Andernfalls fließt kein Strom über den Transistor. Die Zustände "Stromfluß über den Transistor" bzw. "kein Stromfluß über den Transistor" sind somit den verschiedenen logischen Informationen zugeordnet.

Zum Löschen der gespeicherten Information in der ferroelektrischen Schicht 132 wird der aus erster Gateelektrode 14 und zweiter Gateelektrode 17 gebildete pn-Übergang in Sperrichtung über seiner Durchbruchsspannung betrieben. Dadurch wird die ferroelektrische Schicht 132 so polarisiert, daß sich der Kanalbereich unterhalb der ersten Gatezwischenschicht 13 in Inversion befindet und daher leitet.

In einem weiteren Ausführungsbeispiel (siehe Figur 2) weist ein Halbleitersubstrat 21 zwei Source-/Drain-Gebiete 22 auf, die analog wie anhand von Figur 1 erläutert, ausgestaltet sind. Zwischen den Source-/Drain-Gebieten 22 ist an der Oberfläche des Halbleitersubstrats 21 eine dielektrische Schicht 26 angeordnet, die eine Schichtdicke von 5 bis 10 nm aufweist und aus CeO₂ oder ZrO₂ ausgebildet ist. An der Oberfläche der dielektrischen Schicht 26 ist eine ferroelektrische Schicht 23 angeordnet, deren Querschnitt parallel zur Oberfläche des Substrats 21 kleiner als der der dielektrischen Schicht 26 ist. Die dielektrische Schicht 26 überragt die ferroelektrische Schicht 23 seitlich. An der Oberfläche der ferroelektrischen Schicht 23 ist eine Hilfsschicht 25 und an der Oberfläche der Hilfsschicht 25 eine erste Gateelektrode 24 angeordnet. Darüber hinaus ist eine zweite Gateelektrode 27 vorgesehen, die beiderseits der ferroelektrischen Schicht 23 auf die Oberfläche der dielektrischen Schicht 26 trifft und die die erste Gateelektrode 24 überdeckt. Die ferroelektrische Schicht 23, die Hilfsschicht 25, die erste Gateelektrode 24 und die zweite Gateelektrode 27 sind analog wie anhand von Figur 1 erläutert, ausgeführt. Die Betriebsweise des in Figur 2 dargestellten ferroelektrischen Transistors erfolgt analog wie anhand von Figur 1 erläutert.

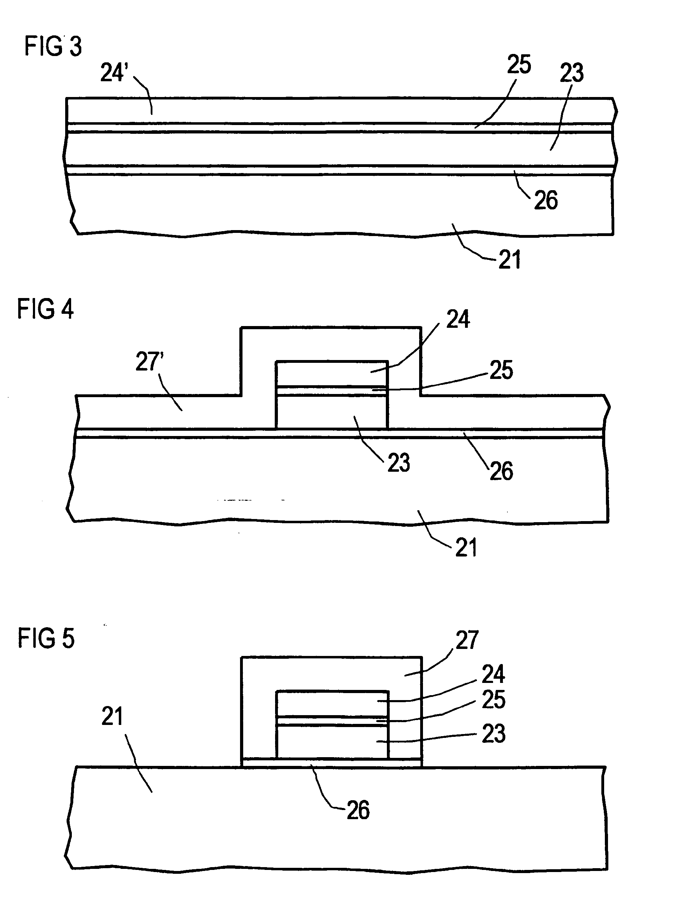

Zur Herstellung des in Figur 2 dargestellten ferroelektrischen Transistors wird auf die Oberfläche des Halbleitersubstrats 21, in dem zunächst aktive und nicht aktive Gebiete durch eine Isolationstechnik, zum Beispiel eine LOCOS-Technik oder eine STI (Shallow Trench Isolation)-Technik, definiert wurden (nicht dargestellt) und in der in bekannter Weise Wannen implantiert wurden (nicht dargestellt), die dielektrische Schicht 26 abgeschieden. Auf die dielektrische Schicht 26 wird die ferroelektrische Schicht 23 mit einem ein- oder mehrstufigen Sol-Gel-Verfahren oder mit einem CVD-Prozeß aufgebracht. Es folgt eine Temperung bei 700°C, um die ferroelektrische Schicht 23 in die gewünschte ferroelektrische Phase zu bringen. Auf die Oberfläche der ferroelektrischen Schicht 23 wird nachfolgend durch Sputtern die Hilfsschicht 25 aus Platin aufgebracht. Auf die Hilfsschicht 25 wird eine p-dotierte Polysiliziumschicht 24' abgeschieden (siehe Figur 3).

Anschließend wird unter Verwendung einer Photolackmaske, die die Form der ersten Gateelektrode 24 definiert, die p⁺⁻dotierte Polysiliziumschicht 24', die Hilfsschicht 25 und die ferroelektrische Schicht 23 bis auf die Oberfläche der dielektrischen Schicht 26 strukturiert. Dazu wird ein mehrstufiges Ätzverfahren eingesetzt, in dem zur Strukturierung der p⁺-dotierten Polysiliziumschicht 24' HBr oder HCl und zur Strukturierung der Hilfsschicht 25 der ferroelektrischen Schicht 26 Cl₂ und/oder Ar mit Zusätzen schwerer Gase wie zum Beispiel SF₆, BCl₃ verwendet wird.

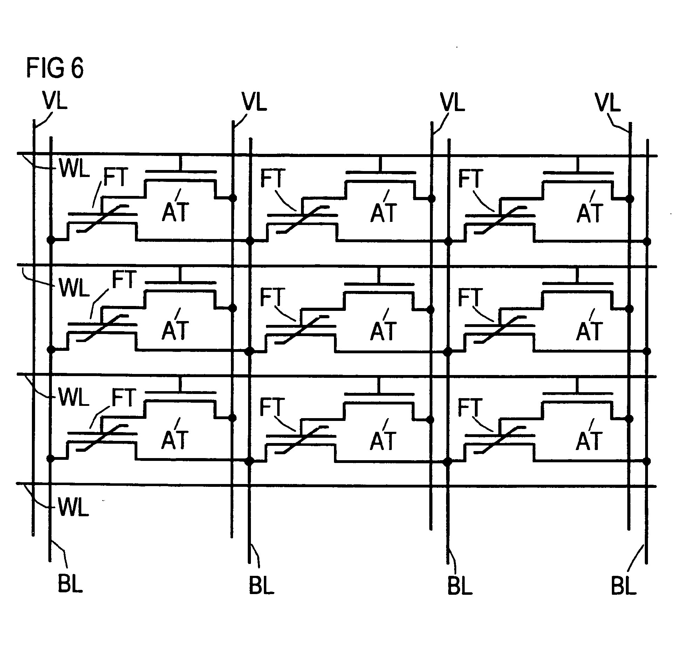

Anschließend wird eine n-dotierte Polysiliziumschicht 27' abgeschieden, die eine Dicke von 120 bis 150 nm aufweist. In einem nachfolgenden, mehrstufigen Ätzprozeß werden die n-dotierte Polysiliziumschicht 27' und die dielektrische Schicht 26 strukturiert, wobei die zweite Gateelektrode 27 gebildet wird. Die zweite Gateelektrode 27 überlappt die erste Gateelektrode 24 seitlich auf beiden Seiten. Zur Strukturierung der n-dotierten Polysiliziumschicht 27' wird HBr oder HCl, der dielektrischen Schicht 26 Cl, Ar oder ein Gemisch aus Cl und Ar mit Zusätzen schwerer Gase wie zum Beispiel SF₆, BCl₃ verwendet (siehe Figur 5).

Durch Implantation mit Arsen werden nachfolgend selbstjustiert zur zweiten Gateelektrode 24 die Source-/Drain-Gebiete 22 implantiert. Dadurch wird der in Figur 2 dargestellte ferroelektrische Transistor fertiggestellt.

Das Herstellverfahren kann auf vielerlei Art variiert werden. Insbesondere kann die Temperung zur Festlegung der gewünschten ferroelektrischen Phase der ferroelektrischen Schicht 23 auch nach der Abscheidung der p-dotierten Polysiliziumschicht 24, wenn die erforderliche Temperatur niedrig genug ist, so daß sich kein SiO₂ über der Hilfsschicht 25 und unter der ersten Elektrode bildet, oder vorzugsweise nach Abscheidung der Hilfsschicht 25 erfolgen. Ferner kann bei der Strukturierung der ersten Gateelektrode 24 die dielektrische Schicht 26 bis auf die Oberfläche des Halbleitersubstrats 21 mitstrukturiert werden und die Temperung nach Bildung der ersten Gateelektrode 24 erfolgen. In diesem Fall kann bei dieser Temperung seitlich der ersten Gateelektrode 24 an der Oberfläche des Halbleitersubstrats 21 eine SiO₂-Schicht gebildet werden, die nachfolgend als Gateoxid unterhalb der zweiten Gateelektrode 27 seitlich der ersten Gateelektrode 24 verwendet wird. Die Temperung wird in diesem Fall vorzugsweise so geführt, daß nicht gleichzeitig eine SiO₂-Schicht zwischen der ersten Gatelektrode 24 und der Hilfsschicht 25 entsteht.

Ferner können die Source-/Drain-Gebiete 22 mit einem LDD-Profil erzeugt werden. Zu diesem Zweck werden im Laufe des Verfahrens Spacer an den Flanken der zweiten Gateelektrode 27 gebildet.

In den Ausführungsbeispielen ist der Aufbau eines n-Kanal-Transistors beschrieben worden. Die Erfindung ist analog für einen p-Kanal-Transistor durchführbar, in diesem Fall sind alle Leitfähigkeitstypen entsprechend zu vertauschen.

In einer Speicherzellenanordnung sind eine Vielzahl Speicherzellen vorgesehen, von denen jede einen ferroelektrischen Transistor FT und einen Auswahltransistor AT aufweist (siehe Figur 6). Der ferroelektrische Transistor FT ist jeweils wie anhand von Figur 1 oder Figur 2 erläutert ausgeführt. Der Auswahltransistor AT ist als MOS-Transistor mit einer Gateelektrode ausgeführt. Die Speicherzellenanordnung umfaßt darüber hinaus Wortleitungen WL, Versorgungsleitungen VL und Bitleitungen BL. Die Wortleitungen WL kreuzen sowohl die Versorgungsleitungen VL als auch die Bitleitungen BL.

Der ferroelektrische Transistor FT jeder der Speicherzellen ist jeweils zwischen zwei benachbarte Bitleitungen BL geschaltet. Der Auswahltransistor AT der entsprechenden Speicherzelle ist zwischen die zweite Gateelektrode des ferroelektrischen Transistors FT und eine Versorgungsleitung VL geschaltet. Die Gateelektrode des Auswahltransistors AT ist mit einer der Wortleitungen WL verbunden.

Die Auswahl einer Speicherzelle erfolgt in der Speicherzellenanordnung über die entsprechende Wortleitung WL und die entsprechende Versorgungsleitung VL.

Das Auslesen der Speicherzelle erfolgt mit Hilfe einer Durchgangsprüfung zwischen den benachbarten Bitleitungen BL, zwischen die der entsprechende ferroelektrische Transistor FT geschaltet ist. Zum Auslesen der Information wird die zugehörige Versorgungsleitung VL mit einem Spannungspegel beaufschlagt, so daß der aus erster Gateelektrode und zweiter Gateelektrode gebildete pn-Übergang in dem ferroelektrischen Transistor in Sperrichtung unterhalb der Durchbruchsspannung betrieben wird. Die zweite Gateelektrode bringt dabei den Kanalbereich des ferroelektrischen Transistors seitlich der ferroelektrischen Schicht lokal in Inversion, ohne dabei den Polarisationszustand der ferroelektrischen Schicht zu verändern. Ein Strom durch den ferroelektrischen Transistor fließt nur dann, wenn die ferroelektrische Schicht so polarisiert ist, daß sich auch unterhalb der ferroelektrischen Schicht der Kanalbereich in Inversion befindet. Ein Strom zwischen den benachbarten Bitleitungen BL kann nur fließen, wenn der ausgewählte ferroelektrische Transistor FT eingeschaltet ist, das heißt, wenn die ferroelektrische Schicht entsprechend polarisiert ist.

Zum Schreiben von Information in den ferroelektrischen Transistor FT einer Speicherzelle erfolgt die Auswahl ebenfalls über die entsprechende Wortleitung WL und die entsprechende Versorgungsleitung VL. In diesem Fall wird die entsprechende Versorgungsleitung VL mit einem Pegel beaufschlagt, durch den der pn-Übergang, der aus erster Gateelektrode und zweiter Gateelektrode des ferroelektrischen Transistors FT gebildet wird, in Durchlaßrichtung betrieben wird. Dadurch wird die ferroelektrische Schicht so polarisiert, daß sich der Kanalbereich unterhalb der ferroelektrischen Schicht in Akkumulation befindet und daher sperrt.

Zum Löschen von Information in dem ferroelektrischen Transistor einer Speicherzelle wird ebenfalls die Speicherzelle über die Wortleitung WL und die Versorgungsleitung VL ausgewählt. An die Versorgungsleitung VL wird ein derartiger Spannungspegel angelegt, daß der aus erster Gateelektrode und zweiter Gateelektrode des ferroelektrischen Transistors gebildete pn-Übergang in Sperrichtung über seiner Durchbruchsspannung betrieben wird. Dadurch wird die ferroelektrische Schicht so polarisiert, daß sich der Kanalbereich unterhalb der ferroelektrischen Schicht in Inversion befindet und daher leitet.

Beim Lesevorgang, Schreibvorgang sowie Löschvorgang sind alle anderen Speicherzellen, die mit denselben Bitleitungen BL bzw. Versorgungsleitungen VL verbunden sind, mit anderen Wortleitungen WL verbunden. Sie sind daher nicht ausgewählt und sperren.

Die unterschiedlichen Betriebszustände Schreiben, Lesen und Löschen werden über unterschiedliche Spannungspegel an der Versorgungsleitung eingestellt. Für den Betrieb der Speicherzellenanordnung mit einem ferroelektrischen Transistor mit einem ferroelektrischen Material mit einer Koerzitivfeldstärke E_{C} von ca. 30 kV/cm und einer dielektrischen Schicht 131 mit einer relativen Dielektrizitätskonstante εᵣ von ca. 20, der analog wie anhand von Figur 1 oder 2 erläutert aufgebaut ist, sind folgende Pegel geeignet:
Lesen: + 0,5 V
Schreiben: + 3 V
Löschen: - 3 V

## Patentansprüche

1. Ferroelektrischer Transistor,
- bei dem in einem Halbleitersubstrat (11, 21) zwei Source/Drain-Gebiete (12, 22) vorgesehen sind,
- bei dem zwischen den Source-/Drain-Gebieten (12, 22) an der Oberfläche des Halbleitersubstrats (11, 21) eine erste Gatezwischenschicht (13, 23) und eine erste Gateelektrode (14, 24) angeordnet sind, wobei die erste Gatezwischenschicht (13, 23, 26) mindestens eine ferroelektrische Schicht (132, 23) enthält,
- bei dem zwischen den Source-/Drain-Gebieten (12, 22) in Richtung einer Verbindungslinie zwischen den Source-/Drain-Gebieten (12, 22) neben der ersten Gatezwischenschicht (13, 23, 26) eine zweite Gatezwischenschicht (16, 26) und eine zweite Gateelektrode (17, 27) angeordnet sind, wobei die zweite Gatezwischenschicht (16, 26) eine dielektrische Schicht (16, 26) enthält,
- bei dem die erste Gateelektrode (14, 24) und die zweite Gateelektrode (17, 27) über eine Diodenstruktur miteinander verbunden sind.

2. Ferroelektrischer Transistor nach Anspruch 1,
- bei dem die zweite Gatezwischenschicht (16) und die zweite Gateelektrode (17) jeweils aus zwei Teilstrukturen zusammengesetzt sind, die spiegelsymmetrisch zu der ersten Gatezwischenschicht (13) angeordnet sind,
- bei dem die beiden Teilstrukturen der zweiten Gateelektrode (17) elektrisch miteinander verbunden sind.

3. Ferroelektrischer Transistor nach Anspruch 1 oder 2, bei dem die erste Gatezwischenschicht (13) eine dielektrische Schicht (131) enthält, die zwischen der Oberfläche des Halbleitersubstrats (11) und der ferroelektrischen Schicht (132) angeordnet ist.

4. Ferroelektrischer Transistor nach Anspruch 3,
bei dem die dielektrische Schicht (26) der ersten Gatezwischenschicht und die dielektrische Schicht (26) der zweiten Gatezwischenschicht als durchgehende dielektrische Schicht (26) ausgestaltet sind.

5. Ferroelektrischer Transistor nach einem der Ansprüche 1 bis 4,
bei dem die erste Gateelektrode (14) und/oder die zweite Gateelektrode (17) Teil der Diodenstruktur sind.

6. Ferroelektrischer Transistor nach Anspruch 5,
- bei dem die erste Gateelektrode (14) polykristallines Silizium, das von einem ersten Leitfähigkeitstyp dotiert ist, aufweist,
- bei dem die zweite Gateelektrode (17) polykristallines Silizium, das von einem zweiten, dem ersten entgegengesetzten Leitfähigkeitstyp dotiert ist, aufweist,
- bei dem die erste Gateelektrode (14) an die zweite Gateelektrode (17) angrenzt.

7. Ferroelektrischer Transistor nach einem der Ansprüche 1 bis 6,
bei dem zwischen der ferroelektrischen Schicht (132) und der ersten Gateelektrode (14) eine Hilfsschicht (15) vorgesehen ist.

8. Ferroelektrischer Transistor nach einem der Ansprüche 1 bis 7,
- bei dem die erste Gatezwischenschicht CeO₂, ZrO₂ oder Y₂O₃, SrTiO₃ enthält,
- bei dem die zweite Gatezwischenschicht (16) SiO₂, CeO₂, ZrO₂ oder SiTiO₃ enthält,
- bei dem die ferroelektrische Schicht (132) Strontium-Wismuth-Tantalat (SBT), Blei-Zirkon-Titanat (PZT), Lithium-Niobat (LiNbO₃) oder Barium-Strontium-Titanat (BST) enthält,
- bei dem das Halbleitersubstrat (11) monokristallines Silizium enthält.

9. Speicherzellenanordnung mit Speicherzellen, die jeweils einen ferroelektrischen Transistors (FT) nach einem der Ansprüche 1 bis 8 enthalten.

10. Speicherzellenanordnung nach Anspruch 9,
- bei der Wortleitungen (WL), Bitleitung (BL), und Versorgungsleitungen (VL) vorgesehen sind, wobei die Wortleitungen (WL) die Versorgungsleitungen und die Bitleitungen kreuzen,
- bei der jede Speicherzelle zusätzlich zu dem ferroelektrischen Transistor (FT) einen Auswahltransistor (AT) mit einer Steuerelektrode aufweist,
- bei der der ferroelektrische Transistor (FT) einer der Speicherzellen jeweils zwischen benachbarte Bitleitung (BL) geschaltet ist,
- bei der der Auswahltransistor (AT) zwischen die zweite Gateelektrode des ferroelektrischen Transistors (FT) und eine der Versorgungsspannungsleitungen (VL) geschaltet ist,
- bei der die Steuerelektrode des Auswahltransistors (AT) mit einer der Wortleitungen (WL) verbunden ist.

11. Verfahren zur Herstellung eines ferroelektrischen Transistors,
- bei dem auf die Oberfläche eines Halbleitersubstrats (21) eine dielektrische Schicht (26), eine ferroelektrische Schicht (23) und eine erste Elektrodenschicht (24') aufgebracht werden,
- bei dem die erste Elektrodenschicht (24') und die ferroelektrische Schicht (23) gemeinsam strukturiert werden, wobei eine erste Gateelektrode (24) entsteht,
- bei dem eine zweite Elektrodenschicht (27') aufgebracht und so strukturiert wird, daß eine zweite Gateelektrode (27) entsteht, die an die erste Gateelektrode (24) angrenzt und die die erste Gateelektrode (24) seitlich überlappt,
- bei dem die Materialien der ersten Gateelektrode (24) und der zweiten Gateelektrode (27) so aufeinander abgestimmt werden, daß die erste Gateelektrode (24) und die zweite Gateelektrode (27) eine Diodenstruktur bilden.

12. Verfahren zur Herstellung eines ferroelektrischen Transistors,
- bei dem auf die Oberfläche eines Halbleitersubstrats (21) eine erste Gatezwischenschicht (26), eine ferroelektrische Schicht (23) und eine erste Elektrodenschicht (24') aufgebracht werden,
- bei dem die erste Elektrodenschicht (24') und die ferroelektrische Schicht (23) und die erste Gatezwischenschicht (26) gemeinsam strukturiert werden, wobei eine erste Gateelektrode (24) entsteht,
- bei dem seitlich der ersten Gatezwischenschicht (26) eine zweite Gatezwischenschicht (16) erzeugt wird, die eine dielektrische Schicht aufweist,
- bei dem eine zweite Elektrodenschicht (27') aufgebracht wird und so strukturiert wird, daß eine zweite Gateelektrode (27) entsteht, die an die erste Gateelektrode (24) angrenzt und die die erste Gateelektrode (24) seitlich überlappt,
- bei dem die Materialien der ersten Gateelektrode (24) und der zweiten Gateelektrode (27) so aufeinander abgestimmt werden, daß die erste Gateelektrode (24) und die zweite Gateelektrode (27) eine Diodenstruktur bilden.

13. Verfahren nach Anspruch 11 oder 12,
- bei dem zwischen der ferroelektrischen Schicht (23) und der ersten Elektrodenschicht (24') eine Hilfsschicht (25) aufgebracht wird, die gemeinsam mit der ferroelektrischen Schicht (23) und der ersten Elektrodenschicht (24') strukturiert wird.

## Claims

1. Ferroelectric transistor,
- in which two source/drain regions (12, 22) are provided in a semiconductor substrate (11, 21),
- in which a first gate intermediate layer (13, 23) and a first gate electrode (14, 24) are arranged between the source/drain regions (12, 22) on the surface of the semiconductor substrate (11, 21), with the first gate intermediate layer (13, 23, 26) containing at least one ferroelectric layer (132, 23),
- in which a second gate intermediate layer (16, 26) and a second gate electrode (17, 27) are arranged between the source/drain regions (12, 22) in the direction of a joining line between the source/drain regions (12, 22) in addition to the first gate intermediate layer (13, 23, 26), with the second gate intermediate layer (16, 26) containing a dielectric layer (16, 26),
- in which the first gate electrode (14, 24) and the second gate electrode (17, 27) are connected to each other via a diode structure.

2. Ferroelectric transistor according to Claim 1,
- in which the second gate intermediate layer (16) and the second gate electrode (17) are respectively made up of two substructures which are arranged mirror-symmetrically in relation to the first gate intermediate layer (13),
- in which the two substructures of the second gate electrode (17) are electrically connected to each other.

3. Ferroelectric transistor according to Claim 1 or 2, in which the first gate intermediate layer (13) contains a dielectric layer (131) which is arranged between the surface of the semiconductor substrate (11) and the ferroelectric layer (132).

4. Ferroelectric transistor according to Claim 3, in which the dielectric layer (26) of the first gate intermediate layer and the dielectric layer (26) of the second gate intermediate layer are formed as a continuous dielectric layer (26).

5. Ferroelectric transistor according to one of Claims 1 to 4, in which the first gate electrode (14) and/or the second gate electrode (17) are part of the diode structure.

6. Ferroelectric transistor according to Claim 5,
- in which the first gate electrode (14) has polycrystalline silicon which is doped of a first conductivity type,
- in which the second gate electrode (17) has polycrystalline silicon which is doped of a second conductivity type, opposed to the first type,
- in which the first gate electrode (14) is adjacent to the second gate electrode (17).

7. Ferroelectric transistor according to one of Claims 1 to 6, in which an auxiliary layer (15) is provided between the ferroelectric layer (132) and the first gate electrode (14).

8. Ferroelectric transistor according to one of Claims 1 to 7,
- in which the first gate intermediate layer contains CeO₂, ZrO₂, Y₂O₃, or SrTiO₃.
- in which the second gate intermediate layer (16) contains SiO₂, CeO₂, ZrO₂, or SrTiO₃,
- in which the ferroelectric layer (132) contains strontium-bismuth-tantalum (SBT), lead-zirconiumtitante (PZT), lithium-niobate (LiNbO₃) or barium-strontium-titanate (BST),
- in which the semiconductor substrate (11) contains monocrystalline silicon.

9. Memory cell arrangement with memory cells which respectively contain a ferroelectric transistor (FT) according to one of Claims 1 to 8.

10. Memory cell arrangement according to Claim 9,
- in which word lines (WL), bit lines (BL) and supply lines (VL) are provided, the word lines (WL) crossing the supply lines and the bit lines,
- in which each memory cell has in addition to the ferroelectric transistor (FT) a selection transistor (AT) with a control electrode,
- in which the ferroelectric transistor (FT) of one of the memory cells is in each case connected between two neighbouring bit lines (BL),
- in which the selection transistor (AT) is connected between the second gate electrode of the ferroelectric transistor (FT) and one of the supply voltage lines (VL),
- in which the control electrode of the selection transistor (AT) is connected to one of the word lines (WL).

11. Method of producing a ferroelectric transistor
- in which a dielectric layer (26), a ferroelectric layer (23) and a first electrode layer (24') are applied to the surface of a semiconductor substrate (21),
- in which the first electrode layer (24') and the ferroelectric layer (23) are structured together, with a first gate electrode (24) being produced,
- in which a second electrode layer (27') is applied and structured in such a way as to produce a second gate electrode (27), which is adjacent to the first gate electrode (24) and which laterally overlaps the first gate electrode (24),
- in which the materials of the first gate electrode (24) and of the second gate electrode (27) are matched to each other in such a way that the first gate electrode (24) and the second gate electrode (27) form a diode structure.

12. Method of producing a ferroelectric transistor
- in which a first gate intermediate layer (26), a ferroelectric layer (23) and a first electrode layer (24') are applied to the surface of a semiconductor substrate (21),
- in which the first electrode layer (24') and the ferroelectric layer (23) and the first gate intermediate layer (26) are structured together, with a first gate electrode (24) being produced,
- in which the second gate intermediate layer (16), which has a dielectric layer, is produced laterally in relation to the first gate intermediate layer (26),
- in which a second electrode layer (27') is applied and structured in such a way as to produce a second gate electrode (27), which is adjacent to the first gate electrode (24) and which laterally overlaps the first gate electrode (24),
- in which the materials of the first gate electrode (24) and of the second gate electrode (27) are matched to each other in such a way that the first gate electrode (24) and the second gate electrode (27) form a diode structure.

13. Method according to Claim 11 or 12,
- in which an auxiliary layer (25) is applied between the ferroelectric layer (23) and the first electrode layer (24') and structured together with the ferroelectric layer (23) and the first electrode layer (24').

## Revendications

1. Transistor ferroélectrique,
- dans lequel il est prévu, dans un substrat (11, 21) semi-conducteur, deux zones (12, 22) de source/drain ;
- dans lequel il est disposé entre les zones (12, 22) de source/drain à la surface du substrat (11, 21) semi-conducteur une première couche (13, 23) intermédiaire de grille et une première électrode (14, 24) de grille, la première couche (13, 23, 26) intermédiaire de grille contenant au moins une couche (132, 23) ferroélectrique ;
- dans lequel il est disposé entre les zones (12, 22) de source/drain, dans la direction d'une ligne de liaison entre les zones (12, 22) de source/drain, outre la première couche (13, 23, 26) intermédiaire de grille, une deuxième couche (16, 26) intermédiaire de grille et une deuxième électrode (17, 27) de grille, la deuxième couche (16, 26) intermédiaire de grille contenant une couche (16, 26) diélectrique ;
- dans lequel la première électrode (14, 24) de grille et la deuxième électrode (17, 27) de grille sont reliées entre elles par une structure de diode.

2. Transistor ferroélectrique suivant la revendication 1,
- dans lequel la deuxième couche (16) intermédiaire de grille et la deuxième électrode (17) de grille sont composées, respectivement, de sous-structures qui sont disposées symétriquement comme en un miroir par rapport à la première couche (13) intermédiaire de grille ;
- dans lequel les deux sous-structures de la deuxième électrode (17) de grille sont reliées électriquement entre elles.

3. Transistor ferroélectrique suivant la revendication 1 ou 2,
- dans lequel la première couche (13) intermédiaire de grille contient une couche (131) diélectrique qui est disposée entre la surface du substrat (11) semi-conducteur et la couche (132) ferroélectrique.

4. Transistor ferroélectrique suivant la revendication 3,
- dans lequel la couche (26) diélectrique de la première couche intermédiaire de grille et la couche (26) diélectrique de la deuxième couche intermédiaire de grille sont constituées sous la forme d'une couche (26) diélectrique continue.

5. Transistor ferroélectrique suivant l'une des revendications 1 à 4,
- dans lequel la première électrode (14) de grille et/ou la deuxième électrode (17) de grille font partie de la structure de diode.

6. Transistor ferroélectrique suivant la revendication 5,
- dans lequel la première électrode (14) de grille a du silicium polycristallin qui est dopé par un premier type de conductivité ;
- dans lequel la deuxième électrode (17) de grille a un silicium polycristallin qui est dopé par un deuxième type de conductivité opposé au premier ;
- dans lequel la première électrode (14) de grille est voisine de la deuxième électrode (17) de grille.

7. Transistor ferroélectrique suivant l'une des revendications 1 à 6,
- dans lequel il est prévu une couche (15) auxiliaire entre la couche (132) ferroélectrique et la première électrode (14) de grille.

8. Transistor ferroélectrique suivant l'une des revendications 1 à 7,
- dans lequel la première couche intermédiaire de grille contient du CeO₂, du ZrO₂ ou de l'Y₂O₃, du SrTiO₃ ;
- dans lequel la deuxième couche (16) intermédiaire de grille contient du SiO₂, du CeO₂, du ZrO₂ ou du SrTiO₃ ;
- dans lequel la couche (132) ferroélectrique contient du tantalate de strontium et de bismuth (SBT), du titanate de plomb et de zirconium (PZT), du niobate de lithium (LiNbO₃) ou du titanate de baryum et de strontium (BST) ;
- dans lequel le substrat (11) semi-conducteur contient du silicium monocristallin.

9. Dispositif de cellules de mémoire ayant des cellules de mémoire qui contiennent, respectivement, un transistor (FT) électrique suivant l'une des revendications 1 à 8.

10. Dispositif de cellules de mémoire suivant la revendication 9,
- dans lequel il est prévu des lignes (WL) de mots, une ligne (BL) de bits et des lignes (VL) d'alimentation, les lignes (WL) de mots croisant les lignes d'alimentation et les lignes de bits ;
- dans lequel chaque cellule de mémoire a, en plus du transistor (FT) ferroélectrique, un transistor (AT) de sélection ayant une électrode de commande ;
- dans lequel le transistor (FT) ferroélectrique de l'une des cellules de mémoire est monté, respectivement, entre des lignes (BL) de bits voisines ;
- dans lequel le transistor (AT) de sélection est monté entre la deuxième électrode de grille du transistor (FT) ferroélectrique et l'une des lignes (VL) de tension d'alimentation ;
- dans lequel l'électrode de commande du transistor (AT) de sélection est reliée à l'une des lignes (WL) de mots.

11. Procédé de production d'un transistor ferroélectrique,
- dans lequel on dépose à la surface d'un substrat 21 semi-conducteur une couche (26) diélectrique, une couche (23) ferroélectrique et une première couche (24') d'électrode ;
- dans lequel on structure en commun la première couche (24') d'électrode et la couche (23) ferroélectrique en créant ainsi une première électrode (24) de grille ;
- dans lequel on dépose une deuxième couche (27') d'électrode et on la structure de façon à créer une deuxième électrode (27) de grille qui est voisine de la première électrode (24) de grille et qui chevauche latéralement la première électrode (24) de grille ;
- dans lequel on adapte les matériaux de la première électrode (24) de grille et de la deuxième électrode (27) de grille l'un à l'autre de façon à ce que la première électrode (24) de grille et la deuxième électrode (27) de grille forment une structure de diode.

12. Procédé de production d'un transistor ferroélectrique,
- dans lequel on dépose sur la surface d'un substrat (21) semi-conducteur une première couche (26) intermédiaire de grille, une couche (23) ferroélectrique et une première couche (24') d'électrode ;
- dans lequel on structure en commun la première couche (24') d'électrode et la couche (23) ferroélectrique et la première couche (26) intermédiaire de grille en créant ainsi une première électrode (24) de grille ;
- dans lequel on produit latéralement à la première couche (26) intermédiaire de grille une deuxième couche (16) intermédiaire de grille qui a une couche diélectrique ;
- dans lequel on dépose une deuxième couche (27') d'électrode et on la structure de façon à créer une deuxième électrode (27) de grille qui est voisine de la première électrode (24) de grille et qui chevauche latéralement la première électrode (24) de grille ;
- dans lequel on adapte les matériaux de la première électrode (24) de grille et de la deuxième électrode (27) de grille l'un à l'autre de façon à ce que la première électrode (24) de grille et la deuxième électrode (27) de grille forment une structure de diode.

13. Procédé suivant la revendication 11 ou 12,
- dans lequel on dépose entre la couche (23) ferroélectrique et la première couche (24') d'électrode une couche (25) auxiliaire que l'on structure en commun avec la couche (23) ferroélectrique et la première couche (24') d'électrode.
